# EUROPEAN PATENT APPLICATION

(11) **EP 2 466 636 A2**
(43) Date of publication of application: **20.06.2012**
(21) Application number: 11193504.5
(22) Date of filing: 14.12.2011
(51) Int. Cl.: H01L 23/433, H01L 23/373

(54) **Adaptive thermal gap pad**

(30) Priority: 20.12.2010 US 973699
(71) Applicant: Raytheon Company, Waltham, MA 02451-1449 (US)
(72) Inventor: Wong, Tse Eric, Los Alamitos, CA 90720 (US); Chu, Charles, Temple City, CA 91780 (US); Koontz, Christopher R., Manhattan Beach, CA 90266 (US); Sumner, Christal J., San Pedro, CA 90731 (US)
(74) Representative: Müller, Wolfram Hubertus

(57) **Abstract**

The present invention relates to a thermal gap pad for transferring heat from a heat-supplying component such as an electronic device, and more specifically to a thermal gap pad with reduced compressive loading. In one embodiment, a thermal assembly includes a heat-supplying component, a cooling structure, a gap pad having a first surface, and a lubricant provided along the first surface of the gap pad. The lubricant has a viscosity of about 500 cP or less. The gap pad is compressed between the heat-supplying component and the cooling structure, such that the first surface of the gap pad is in thermal contact with the cooling structure.

## Description

### FIELD OF THE INVENTION

The present invention relates to a thermal gap pad for transferring heat between a heat-supplying component, such as an electronic device, and a cooling structure such as a heat sink, and more specifically to a thermal gap pad with reduced compressive loading.

### BACKGROUND

Thermal gap pads are used in various devices to provide heat transfer between a heat-supplying component and a cooling structure such as a heat sink. These gap pads provide physical contact between the heat-supplying component and the heat sink to conduct heat away from the component. For example, gap pads are useful in devices where heat-supplying components may have various sizes and manufacturing tolerances that result in small gaps between the components and the heat sink. A gap pad can be inserted into the gap to accommodate such manufacturing tolerances and improve thermal conduction to the heat sink.

In order to accommodate various gap sizes and maintain contact between the heat sink and the heat-supplying component during operation, in the past, thermal gap pads have been designed to have a thickness that is larger than the gap. When the device is assembled, the pad is compressed between the heat sink and the heat-supplying component. As an example, the pad may be compressed into a gap that is about 50% of the pad's thickness. This compression results in compressive forces exerted by the pad against the heat sink and against the heat-supplying component. In some cases, the compressive forces may be too large, causing the heat-supplying component (such as an electronic component) or connected structures (e.g., solder joints) to bend or crack, which can lead to failure or reduced reliability. In other cases, the compressive forces may be too small, causing the gap pad to lose contact between the heat-supplying component and the heat sink, resulting in a loss of thermal conduction. A minimal level of compression is desirable to maintain adequate thermal conductivity through the gap pad. Additionally these gap pads may be used in devices that are not designed to be disassembled, so the gap pad cannot be easily replaced.

Accordingly there is still a need for a thermal gap pad that maintains contact and thermal conduction between the heat-supplying component and the cooling structure while reducing the compressive load on the heat-supplying component and cooling structure.

### SUMMARY

The present invention relates to a thermal gap pad for transferring heat from a heat-supplying component, such as an electronic device, and more specifically to a thermal gap pad with reduced compressive loading. In one embodiment, a device includes a heat-supplying component such as an electronic component or sub-assembly, and a cooling structure such as a heat sink or cold plate. A thermal gap pad is inserted into the gap between the electronic component and the cooling structure. The thermal gap pad includes a lubricant along the surface of the pad contacting the cooling structure. During assembly, the components are moved together and the gap pad is compressed in the gap. The lubricant along the surface of the pad allows that surface of the pad to slide with reduced friction along the cooling structure as the gap pad is compressed. The reduced friction along this surface enables the gap pad to slide and expand outwardly to accommodate the compression. As a result the pad can be compressed into the gap with a reduced compressive force. The thermal gap pad of the present invention may be used in various types of applications, including inside electronic devices such as computers, sensors, and other devices located on aircraft, military, industrial, and commercial equipment, and other applications.

In one embodiment, a thermal assembly includes a heat-supplying component, a cooling structure, a gap pad having a first surface, and a lubricant provided along the first surface of the gap pad. The lubricant has a viscosity of about 500 cP (centiPoise) or less. The gap pad is compressed between the heat-supplying component and the cooling structure, such that the first surface of the gap pad is in thermal contact with the cooling structure.

The first surface of the gap pad may comprise a plurality of grooves, wherein the lubricant is received in the grooves. The compressed gap pad may be substantially free of openings or voids in the gap pad. The lubricant may comprise silicone. The heat-supplying component may comprise an electronic component.

In one embodiment, a thermal assembly includes a heat-supplying component, a cooling structure, and a gap pad compressed between the heat-supplying component and the cooling structure. A coefficient of friction between the gap pad and the cooling structure is approximately 0.05 or less.

The heat-supplying component may comprise an electronic component.

In one embodiment, a method of assembling a thermal assembly includes providing a heat-supplying component and a cooling structure; providing a gap pad having a lubricant along a first surface of the gap pad; inserting the gap pad between the heat-supplying component and the cooling structure with the first surface of the gap pad contacting the cooling structure; and compressing the gap pad between the heat-supplying component and the cooling structure. Compressing the gap pad includes sliding the first surface of the gap pad along the cooling structure. The heat-supplying component may be an electronic component.

### BRIEF DESCRIPTION OF THE DRAWINGS

Figure 1 is a partial side view of an electronic device and a cooling structure.
Figure 2 is a partial side view of an electronic device, a cooling structure, and a thermal gap pad prior to compressive loading, according to an embodiment of the invention.
Figure 3 is a partial side view of an electronic device, a cooling structure, and a thermal gap pad under compressive loading, according to an embodiment of the invention.
Figures 4A-E are perspective views of various thermal gap pads according to embodiments of the invention.
Figure 5 is a flowchart showing a method of assembling an electronic device according to an embodiment of the invention.

### DETAILED DESCRIPTION

The present invention relates to a thermal gap pad for transferring heat from a heat-generating component, such as an electronic device, and more specifically to a thermal gap pad with reduced compressive loading. In one embodiment, a device includes a heat-supplying component such as an electronic component or sub-assembly, and a cooling structure such as a heat sink or cold plate. A thermal gap pad is inserted into the gap between the electronic component and the cooling structure. The thermal gap pad includes a lubricant along the surface of the pad contacting the cooling structure. During assembly, the components are moved together and the gap pad is compressed in the gap. The lubricant along the surface of the pad allows that surface of the pad to slide with reduced friction along the cooling structure as the gap pad is compressed. The reduced friction along this surface enables the gap pad to slide and expand outwardly to accommodate the compression. As a result the pad can be compressed into the gap with a reduced compressive force. The thermal gap pad of the present invention may be used in various types of applications, including inside electronic devices such as computers, sensors, and other devices located on aircraft, military, industrial, and commercial equipment, and other applications.

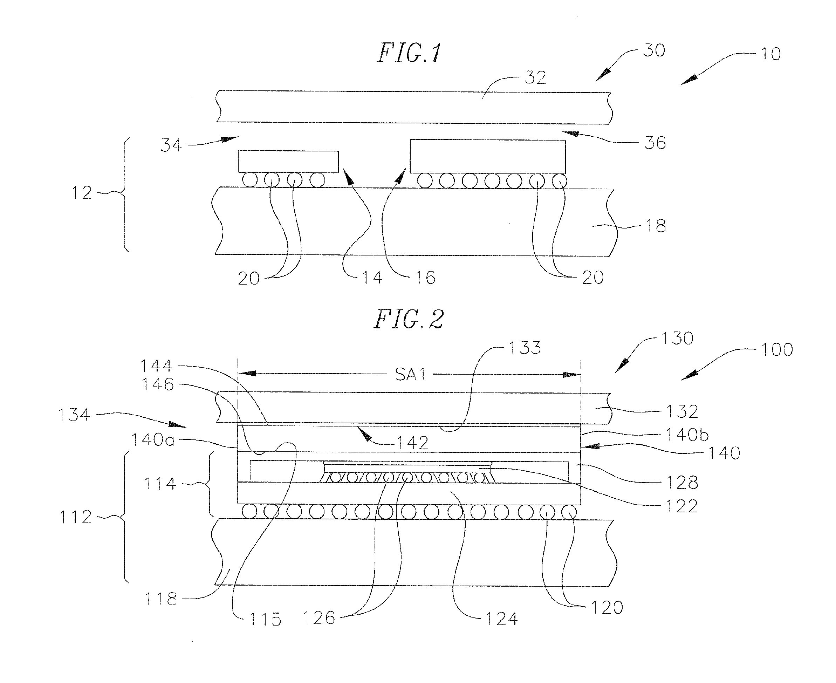

An electronic assembly 10 is shown in Figure 1 as an example of an assembly with a heat-supplying component. The electronic assembly includes an electronic device 12 with two heat-supplying components or sub-assemblies 14, 16. In this particular example the two heat-supplying components 14, 16 are mounted to a printed wiring board 18 at several solder joints 20. The assembly also includes a cooling structure 30 including a heat sink 32. The heat sink 32 is cooled by other components of the cooling structure and is located near the heat-supplying components 14, 16 to transfer heat from these components during operation of the device.

However, a gap 34, 36 exists between each component 14, 16 and the heat sink 32. The two gaps 34, 36 may be different sizes, as shown in Figure 1, or they could be similar sizes or the same size. The gaps may be present due to manufacturing and/or assembly tolerances in the electronic assembly 10, or due to the geometry and packaging of other components. The gaps may also be present due to vibrations, loads, or movements during operation of the device. When the gaps 34, 36 are left empty and not filled, the heat generated by the components 14, 16 is not effectively transferred to the heat sink 32 to cool the system, and the components 14, 16 can overheat and fail, and/or can cause other components along a cooling path to overheat and fail.

Accordingly, a gap pad is inserted into the gap between the heat-supplying component and the cooling structure. A thermal assembly 100 according to an embodiment of the invention is shown in Figure 2, with a gap pad 140, prior to compressive loading. In this example the thermal assembly 100 includes an electronic device 112 with a heat-supplying electronic component or sub-assembly 114, mounted on a printed wiring board 118 at solder joints 120. In the example shown, the sub-assembly 114 includes a processor chip 122 mounted to a substrate 124 at solder joints 126, inside a cover or housing 128. The solder joints 120, 126 are shown as an example of a connection package for mounting an electronic component to a substrate or circuit board. The solder joints may be, for example, solder balls that form a ball grid array which is used as the surface mount for the processor chip. Other surface mount packages may be used, such as pin grid array, column grid array, or others. The electronic sub-assembly 114 may be referred to as an electronic component, and 112 as a circuit card assembly. The sub-assembly with the ball grid array and processor chip is shown in Figure 2 as an example of a heat-supplying electronic component 114. Other embodiments may include other types of heat-supplying components, such as transistors, integrated circuits, various processor chips, and other surface-mount packages, such as pin grid array, column grid array, and others.

Additionally, the heat-supplying component is not limited to an electronic device. Various types of electronic and non-electronic heat-supplying components may be utilized in the thermal assembly 100. For example, the heat-supplying component may be a thermal strap which is carrying heat to another part of a cooling system. As another example, the heat-supplying component may be a frictional component such as a brake pad. The electronic device 112 with a heat-supplying electronic component or sub-assembly 114 are shown in Figure 2 as simply one example of a heat-supplying component. As used herein, "heat-supplying" includes heat-transferring as well as heat-generating components.

The assembly also includes a cooling structure 130 such as a heat sink 132. The thermal gap pad 140 is inserted into the gap 134 between the heat-supplying component 114 and the heat sink 132. The cooling structure 130 may include a mechanism for transferring heat through a short or long conduction path. For example, the cooling structure 130 may include heat straps or other components that connect to remote parts of a cooling system to transfer heat. The structure 130 may include one or more heat straps that connect to a cold plate located away from the component 112. The structure 130 may include a cold plate adjacent to the gap pad. Many types of cooling systems are contemplated, with the gap pad inserted between the heat-supplying component and a surface of the cooling structure.

Referring again to Figure 2, a lubricant 142 is provided between the thermal gap pad 140 and the heat sink 132. In the embodiment of Figure 2, the lubricant 142 is provided as a coating along the top surface 144 of the gap pad facing the lower surface 133 of the heat sink. The lubricant 142 reduces the coefficient of friction between the gap pad 140 and the heat sink 132 to facilitate sliding movement of the gap pad along the surface 133 when the gap pad is compressed. In one embodiment, the lower surface 133 of the heat sink is substantially smooth or flat where it contacts the lubricant and the gap pad.

When the coefficient of friction between the two surfaces 144 and 133 is high, the friction between the surfaces resists movement of the gap pad along the surface 133 of the heat sink 132 during compression. As a result, when the thermal assembly 100 is assembled and the gap pad 140 is compressed between the heat sink 132 and the electronic component 114, the top surface 144 of the gap pad resists movement along the lower surface 133 of the heat sink. Friction between the gap pad and the electronic component 114 may similarly cause a resistance to movement at the interface between the lower surface 146 of the gap pad and the upper surface 115 of the electronic component. As a result, during compression, the gap pad bulges outwardly at the exposed sides (such as sides 140a, 140b) and resists movement along the surfaces 133, 115. A large compression force is used during assembly in order to cause the gap pad to bulge outwardly a sufficient amount to compress into the gap 134.

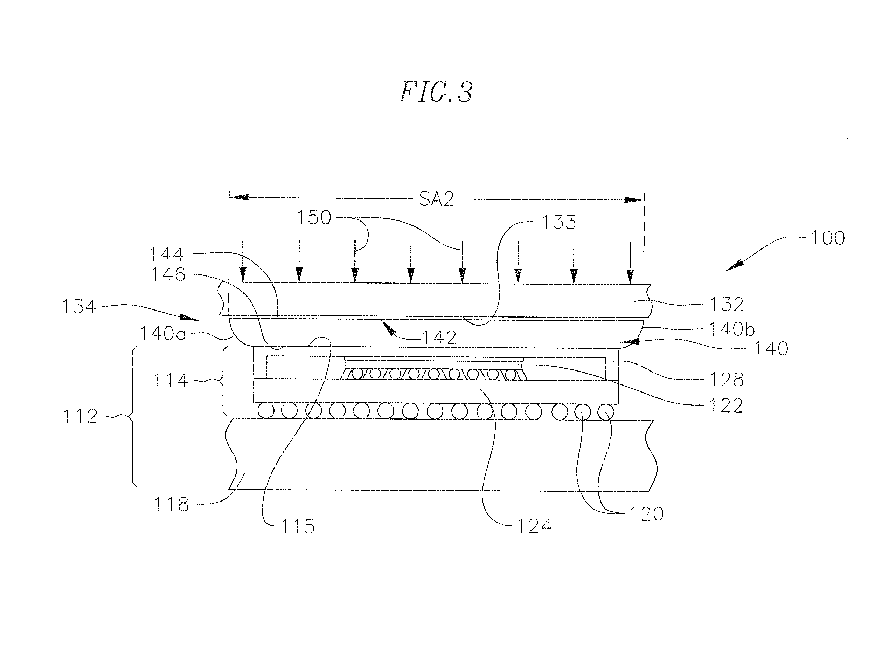

In an embodiment of the invention, the lubricant 142 reduces the coefficient of friction between the surfaces 144 and 133 and enables the gap pad 140 to slide along the surface 133 during compression, as shown in Figure 3. In Figure 3, a compressive load 150 is applied as indicated by the arrows, in order to assemble the components together into the desired package. The lubricant 142 enables the top surface 144 of the gap pad 140 to slide along the lower surface 133 of the heat sink 132 during compression. The surface 144 slides and expands outwardly to accommodate the compression. As a result, the compressive force applied during the assembly process to compress the pad 140 into the gap 134 is reduced.

In one embodiment, the lubricant 142 is provided between the surface 144 of the gap pad and the facing surface 133 of the heat sink 132, but is omitted between the surface 146 of the gap pad and the facing surface 115 of the electronic component 114 (such as the top surface of the housing 128). As a result, in one embodiment, the coefficient of friction between the gap pad and the heat sink is less than the coefficient of friction between the gap pad and the electronic component 114. This difference in coefficients of friction may be desired in order to prevent the gap pad from sliding off of the electronic component 114. During compression, the surface 146 of the gap pad contacting the electronic component retains a higher level of friction than the opposite surface 144, and keeps the pad in place on the electronic component. Lubricant may also be omitted at this interface if the electronic component 114 is sensitive to moisture or lubrication, to prevent the lubricant from leaking into the electronic component 114. Meanwhile the lubricant 142 provided on the opposite surface 144 between the gap pad and the heat sink allows for increased sliding movement and a reduced compression force.

However in other embodiments, a lubricant may be provided between the surfaces 146, 115 as well as between the surfaces 144, 133. The two lubricants may be the same lubricant or they may be different lubricants. The lubricants may be adjusted so that the coefficients of friction at the two interfaces differ. For example, less lubricant or a more viscous lubricant may be used at surfaces 146, 115 in order to provide a higher coefficient of friction at that interface than at surfaces 144, 133.

In an embodiment, with the lubricant 142, the coefficient of friction between the lubricated gap pad 140 and heat sink 132 is approximately 0.01 or less, and in another embodiment approximately 0.02 or less, and in another embodiment approximately 0.05 or less.

As shown in Figures 2-3, the lubricant 142 between the gap pad and the heat sink enables the top surface 144 of the gap pad to slide outwardly during compression. To accommodate the compressive load 150, the gap pad actually expands outwardly and slides along the surface 133. The lubricant enables the ends 140a, 140b of the pad to be unconstrained where the pad contacts the heat sink, rather than restricted by friction with the heat sink 132, so the pad 140 can slide and expand. As a result the surface area of the gap pad contacting the heat sink increases during compression. That is, in Figure 2, prior to compression, the gap pad has a first surface area SA1 contacting the heat sink 132. In Figure 3, after compression, the gap pad has a second surface area SA2 contacting the heat sink 132. The second compressed surface area SA2 is larger than the first uncompressed surface area SA1. In one embodiment, the surface area SA2 is approximately 20% larger than the first surface area SA1. The amount of expansion of the surface area may depend on the initial size of the gap pad. In one embodiment, the surface area SA2 is greater than a surface area of the gap pad contacting the electronic device.

As mentioned above, the lubricant 142 reduces the coefficient of friction between the gap pad and the heat sink and enables the gap pad to slide and expand along the surface of the heat sink, thereby reducing the compressive load applied to the electronic assembly to compress the gap pad into the gap. In one embodiment, the compressive load is reduced by about 50% or more, and in another embodiment, by about 60% or more. That is, less force is applied to compress the gap pad into a given gap size. In particular, in one embodiment, the load applied to compress a gap pad with a thickness of 60 mils (0.060 inches) into a gap of 30 mils (0.030 inches) is approximately 80 psi without lubricant, and 30 psi with lubricant.

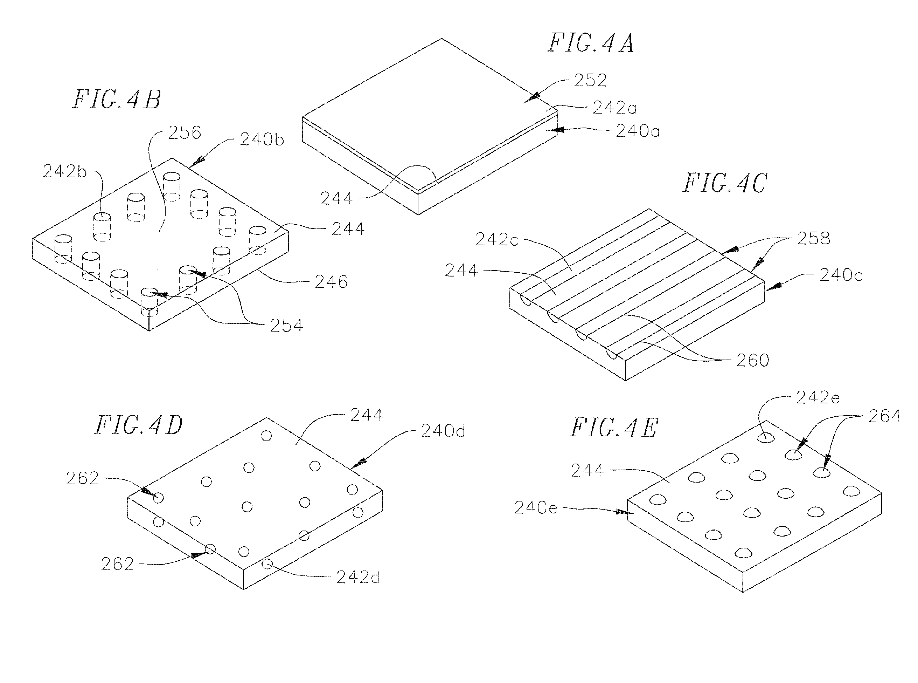

Various configurations of the gap pad may be used to provide the lubricant between the gap pad and the heat sink. A few examples are shown in Figures 4A-4E. For example, in the embodiment of Figure 4A, a lubricant 242a is provided as a uniform coating 252 along the top surface 244 of a gap pad 240a. The coating 252 extends across the top surface 244 with a uniform thickness. As an example, the gap pad 240a may have a thickness of about 60 mils (0.06 inches), and the coating 252 may have a thickness of about 3 mils (0.003 inches). During compression of the pad into the gap (see Figures 2-3), the lubricant 242a enables the top surface 244 of the gap pad to slide along the heat sink (such as a cold plate or other cooling structure). The gap pad 240a may include a separate release liner (not shown) covering the coating 252 until the gap pad is ready to be assembled, at which time the release liner is peeled away and removed from the gap pad, exposing the top surface of the coating 252. The release liner retains and protects the lubricant in the gap pad until the gap pad is ready for use. The release liner may be, for example, a silicone-coated paper or a thin plastic sheet. The release liner may also be provided in the configurations described below.

In Figure 4B, a gap pad 240b includes holes 254 that pass through the top surface 244 of the gap pad through the pad and through the bottom surface 246 of the pad. These holes 254 are filled with a lubricant 242b. During compression of the gap pad between the electronic component and the cooling structure, the gap pad bulges and expands into the holes 254, causing the lubricant to flow up out of the holes 254 and onto the surface 244 between the gap pad and the cooling structure. The lubricant flows between the gap pad and the cooling structure and reduces friction between the two surfaces to enable the gap pad to slide and expand outwardly during compression. Optionally, the gap pad 240b may include a solid central area 256 that is devoid of the holes 254, to reduce the amount of lubricant flowing out of the holes onto the electronic component during compression. The electronic component may be positioned under the solid central area 256, to maintain adequate / better thermal transfer from the central chip 122 in Figure 2.

In Figure 4C, a gap pad 240c includes depressions 258 in a top surface 244 of the gap pad. The depressions 258 are shown as elongated, parallel grooves 260 in the top surface 244. In other embodiments the depressions 258 may take other shapes, such as spaced-apart dimples. A lubricant 242c is received into the depressions 258. During compression, the gap pad stretches and expands, causing the depressions 258 to become more shallow. This causes the lubricant 242c to flow up out of the depressions and along the top surface 244 of the pad over and between the depressions, reducing the coefficient of friction between the gap pad and the cooling structure.

In Figure 4D, a gap pad 240d includes pockets or pores 262 embedded within the gap pad, and a lubricant 242d fills the pockets or pores 262. During compression, the gap pad stretches into and squeezes these pockets 262, causing the lubricant to flow out of the gap pad and onto the top surface 244.

In Figure 4E, a gap pad 240e includes a top surface 244 with domes or bubbles 264 that each contain an amount of lubricant 242e. The domes may be sealed with a thin film. During compression, the compressive force breaks the film and releases the lubricant, which then flows over the top surface 244. The film may be, for example, paraffin.

Various materials are available options for the gap pad. For example, the gap pad may be made from silicone. The gap pad may be a silicone-based polymeric suspension infused with boron nitride or aluminum oxide (Al₂O₃) spheres. The gap pad may be a rubber material or a suitable polymer chain. In another embodiment the pad may be a putty or clay-type material. In various embodiments the gap pad is thermally conductive, so that it can transfer heat from the electronic component to the heat sink. In various embodiments the gap pad is resilient, tending to spring back from compression, so that it maintains contact with the electronic device and the cooling structure across the gap during operation or movement of the device. The gap pad may be deformable under pressure, and resilient, tending to recover its shape after deformation.

As just described, various configurations of the gap pad include holes, depressions, grooves, and other features in the top surface 244 of the gap pad to receive the lubricant. In one embodiment, these features are sized and spaced apart from each other such that when the gap pad is compressed during assembly, the features get compressed and closed by the gap pad, forcing the lubricant out of the gap pad. The gap pad material moves into the holes or grooves, closing them. Thus after compression, the surface area along the top surface 244 of the gap pad in thermal contact with the cooling structure is not diminished by the holes, depressions, grooves, or other surface features, because these features have been filled by the gap pad itself during compression. After compression, the top surface 244 is in substantially continuous thermal contact with the cooling structure, rather than being interspersed with these holes or depressions where no contact is made. It should be understood that the lubricant may remain between the gap pad and the cooling structure after compression. References to thermal contact between the gap pad and the cooling structure is not intended to exclude the presence of any lubricant here as well. It should also be understood that after compression, some holes, grooves, or other surface features may not be completely filled by the compressed gap pad, and some holes or shallow grooves may remain. However these features are substantially filled. The lubricant occupies these remaining holes, providing thermal transfer between the gap pad and the cooling structure and keeping them in contact with each other. Thus after compression, the resilient gap pad is present between the cooling structure and the electronic device across substantially all of the surface area within the perimeter of the gap pad, rather than including gaps or spaces where no gap pad is present.

The lubricant may be selected from various options. In various embodiments, the lubricant is a silicone lubricant, a water-based silicone, a polyether lubricating oil, a perfluorinated fluid, a silicate ester, a synthetic lubricant, polytetrafluoroethylene, a ceramic powder, graphene, and/or other suitable oils, greases, and lubricants. In one embodiment the lubricant has a viscosity in the range of about 100 cP (centiPoise) at about 30-100 °C, and in another embodiment the lubricant has a viscosity less than about 500 cP. The lubricant has a lower viscosity than a thermal grease, which may have a viscosity on the order of 101"5 cP. A lower viscosity provides a lower resistance to shear forces and sliding movement, so that the lubricant can enable the gap pad to slide, as described above, unlike more viscous thermal greases. Herein, the term "grease" is used to refer to these more viscous compounds, while "lubricant" is used to refer to less viscous compounds. Examples of a suitable lubricant are Braycote 600 EF and Braycote 815Z (from Castrol@) and, for contrast, examples of a more viscous grease include TX-2 thermal compound (from Tuniq Co. Ltd.) and T650, T660, and T670 thermal greases (from Parker Chomerics, Parker Hannifin Corporation). In one embodiment the lubricant is not resilient or springy, as the gap pad may be.

The selected lubricant should be able to transfer heat between the gap pad and the cooling structure. In one embodiment, the lubricant has a thermal conductivity of about 0.2 W/m-K (Watts per Kelvin per meter) or greater. In one embodiment the gap pad has a thermal conductivity of about 1.5 W/m-K or greater, and in another embodiment greater than about 15 W/m-K.

Several lubricants were tested to determine the compressive load necessary to achieve a 50% strain. One unlubricated thermal gap pad (the "Dry" samples below) and five lubricated gap pads were tested under the following test conditions. The gap pad was a Laird T-Flex 650 gad pad with an initial thickness of 0.05 inches. The test area compressed was 1.3 inches by 1.3 inches in size. Each pad was compressed at a compression rate of 0.02 inches per minute. The compression machine was an Instron® testing machine, with aluminum compression surfaces, and the test was performed at room temperature. One to five samples of each gap pad were tested, as indicated below.

The results of this testing are shown below in Table 1.

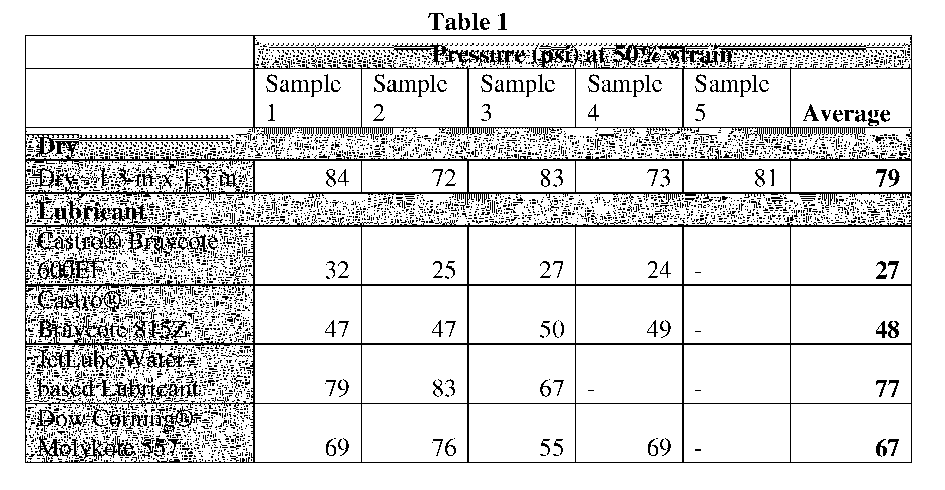

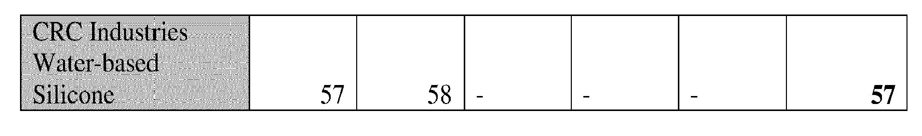

These results indicate that the lubricants generally reduced the compressive force necessary to achieve 50% compression of the gap pad. In one embodiment, with Braycote 600EF lubricant, the compressive force to reach 50% strain was reduced by about 65% as compared to the dry sample.

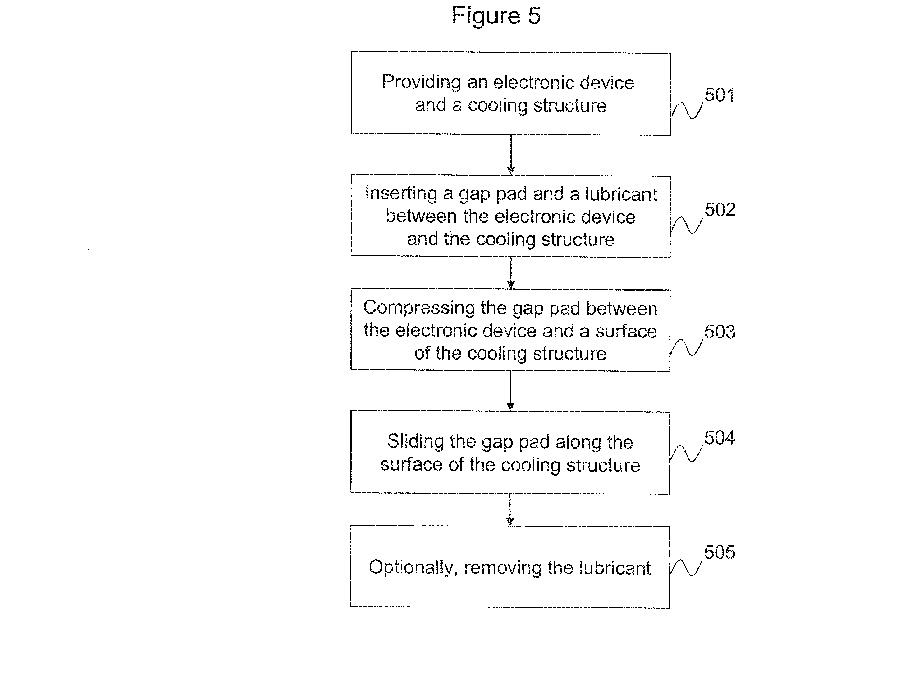

Figure 5 shows a method of assembling a thermal assembly, according to an embodiment of the invention. The method includes providing a heat-supplying component and a cooling structure (501), and inserting a gap pad and a lubricant between the heat-supplying component and the cooling structure (502). In one embodiment the lubricant is provided as a coating along a first surface of the gap pad, and inserting the gap pad includes inserting the gap pad with the coating of lubricant contacting the cooling structure (such as a cold plate). In other embodiments the lubricant is provided in other configurations. For example the lubricant may be provided within one or more depressions in a first surface of the gap pad, and the gap pad is inserted such that the surface with the depressions contacts the cooling structure.

The method then includes compressing the gap pad between the heat-supplying component and a surface of the cooling structure (503). In one embodiment, compressing the gap pad includes applying a compressive pressure of about 200 psi. It should be understood that the compressive force depends on many variables, such as temperature. In one embodiment, compressing the gap pad includes applying a compressive pressure of about 80 psi without lubricant, and about 40 psi with lubricant to compress a gap pad into a gap that is about 50% of the pad's thickness, such as from 0.06 inches to about 0.03 inches.

The method also includes sliding the gap pad along the surface of the cooling structure (504). During compression, the lubricant reduces the coefficient of friction between the gap pad and the cooling structure and enables the gap pad to slide along the surface of the cooling structure.

Optionally, the method also includes removing the lubricant (505) after compression. For example, after the compressive load has been applied and the gap pad compressed to the desired size between the components, the assembly may be heated to evaporate or cure the lubricant. After this heating, the coefficient of friction between the gap pad and the cooling structure is increased, as the lubricant is removed or is cured into a more viscous form. As another option, the lubricant may be removed by applying a vacuum to evacuate the lubricant, or by applying a flow of gas such as CO₂ to remove the lubricant.

This removal or curing step may be desired in applications where lubricant is helpful during compression but is less desirable during operation. For example, it may be desired to isolate an electronic component from lubricant during operation. As another example, it may be desired to increase the coefficient of friction between the gap pad and the cooling structure after compression, in order to set the components in place and prevent further movement during operation of the device. For example, the assembly may be subjected to forces, loads, and other movement during operation, and the increased coefficient of friction may help to retain the gap pad in place and in contact with both the cooling structure and the heat-supplying component during operation.

In one embodiment, the lubricant is a water-based lubricant, which can be removed from the assembly after compression, such as by heating the assembly and causing the lubricant to evaporate. In another embodiment the lubricant becomes absorbed into the gap pad by heating the lubricant after assembly.

In one embodiment, a method of assembly includes providing a gap pad, coating the gap pad with a lubricant, and then inserting the gap pad between the heat-supplying component and the heat sink. In another embodiment, the method includes coating a surface of the heat sink with the lubricant, and then inserting the gap pad into the gap, with one surface of the gap pad contacting the lubricant.

It should be noted that dimensions are exaggerated in the figures for clarity and are not necessarily to scale.

After installation, in one embodiment, the compressed gap pad may exert a force on the heat-supplying component that is less than the maximum allowable loading criterion. In one embodiment, the heat-supplying component is a ball grid array with a maximum allowable loading criterion on the order of approximately 40 psi, and in another embodiment the heat-supplying component has a maximum allowable loading criterion on the order of approximately 70 psi. The maximum allowable loading criteria for other structures will vary based on the components and applications.

Although the present invention has been described and illustrated in respect to exemplary embodiments, it is to be understood that it is not to be so limited, and changes and modifications may be made therein which are within the full intended scope of this invention as hereinafter claimed. For example, the gap pad may have various dimensions and shapes, and can be used in different applications with varying types of electronic or other heat-supplying components.

## Claims

1. A thermal assembly comprising:
a heat-supplying component;
a cooling structure;
a gap pad having a first surface; and
a lubricant provided along the first surface of the gap pad, the lubricant having a viscosity of about 500 cP or less,
wherein the gap pad is compressed between the heat-supplying component and the cooling structure, such that the first surface of the gap pad is in thermal contact with the cooling structure.

2. The thermal assembly of claim 1, wherein the lubricant comprises a coating along the first surface of the gap pad.

3. The thermal assembly of claim 1, wherein the gap pad comprises a plurality of holes through the first surface of the gap pad, and wherein the lubricant is received in the holes.

4. The thermal assembly of claim 1, wherein the first surface of the gap pad comprises a plurality of depressions, and wherein the lubricant is received in the depressions.

5. The thermal assembly of claim 1, wherein the gap pad comprises a plurality of pockets within the gap pad, and wherein the lubricant is received in the pockets.

6. The thermal assembly of claim 1, wherein the lubricant is sealed within a film on the first surface of the gap pad.

7. The thermal assembly of claim 1, wherein a coefficient of friction between the first surface of the gap pad and the cooling structure is approximately 0.05 or less.

8. The thermal assembly of claim 1, wherein the first surface of the gap pad has a first uncompressed surface area and a second compressed surface area, and wherein the second compressed surface area is at least about 20% larger than the first uncompressed surface area.

9. A thermal assembly comprising:
a heat-supplying component;
a cooling structure; and
a gap pad compressed between the heat-supplying component and the cooling structure,
wherein a coefficient of friction between the gap pad and the cooling structure is approximately 0.05 or less.

10. The thermal assembly of claim 9, further comprising a lubricant between the gap pad and the cooling structure.

11. The thermal assembly of claim 10, wherein the lubricant comprises a viscosity of about 500 cP or less, and wherein the gap pad comprises a thermal conductivity of about 1.5 W/m-K or greater.

12. A method of assembling a thermal assembly, comprising:
providing a heat-supplying component and a cooling structure;
providing a gap pad having a lubricant along a first surface of the gap pad;
inserting the gap pad between the heat-supplying component and the cooling structure, with the first surface of the gap pad contacting the cooling structure; and
compressing the gap pad between the heat-supplying component and the cooling structure, wherein compressing the gap pad comprises sliding the first surface of the gap pad along the cooling structure.

13. The method of claim 12, further comprising removing the lubricant after compressing.

14. The method of claim 12, wherein the gap pad comprises a thermal conductivity of about 1.5 W/m-K or greater, and wherein compressing the gap pad comprises applying a compression force of about 40 psi or less.

15. The method of claim 12, wherein compressing the gap pad comprises increasing a surface area of the gap pad in thermal contact with the cooling structure.
